(19) Europäisches Patentamt / European Patent Office / Office européen des brevets

(11) **EP 3 848 953 A1**

(12) **EUROPEAN PATENT APPLICATION**

(43) Date of publication:
14.07.2021 Bulletin 2021/28

(51) Int Cl.:
*H01J 37/28* (2006.01)          *H01J 37/06* (2006.01)
*H01J 37/073* (2006.01)

(21) Application number: 20150403.2

(22) Date of filing: 07.01.2020

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
KH MA MD TN

(71) Applicant: ASML Netherlands B.V.
5500 AH Veldhoven (NL)

(72) Inventor: DE JAGER, Pieter, Willem, Herman
5500 AH Veldhoven (NL)

(74) Representative: ASML Netherlands B.V.
Corporate Intellectual Property
P.O. Box 324
5500 AH Veldhoven (NL)

(54) **HIGH BRIGHTNESS ELECTRON SOURCE**

(57)    Systems and methods for enhancing inspection throughput with a high brightness electron source are described. A plurality of pulsed constituent electron beams are generated. In some embodiments, generating the constituent electron beams comprises causing energy spread in individual beams. The plurality of pulsed constituent electron beams are combined into a combined electron inspection beam using a deflecting cavity. The combined electron inspection beam has a greater brightness than each of the individual constituent pulsed electron beams. In some embodiments, the combined electron inspection beam is passed through a curved path such as a chicane and then accelerated. In some embodiments, a spherical aberration associated with the electron inspection beam is corrected with a multipole corrected. A substrate may be inspected with the combined electron inspection beam. The greater brightness and/or other characteristics of the combined electron inspection beam enhances the inspection throughput.

FIG. 4

**Description**

**TECHNICAL FIELD**

The description herein relates generally to a high brightness electron source.

**BACKGROUND**

A lithographic projection apparatus can be used, for example, in the manufacture of integrated circuits (ICs). A patterning device (e.g., a mask) may include or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatus, the pattern on the entire patterning device is transferred onto one target portion in one operation. Such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively. Since, in general, the lithographic projection apparatus will have a reduction ratio M (e.g., 4), the speed F at which the substrate is moved will be 1/M times that at which the projection beam scans the patterning device. More information with regard to lithographic devices can be found in, for example, US 6,046,792, incorporated herein by reference.

Prior to transferring the pattern from the patterning device to the substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish the individual layer of the device. If several layers are required in the device, then the whole procedure, or a variant thereof, is repeated for each layer. Eventually, a device will be present in each target portion on the substrate. These devices are then separated from one another by a technique such as dicing or sawing, such that the individual devices can be mounted on a carrier, connected to pins, etc.

Manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc.

Lithography is a central step in the manufacturing of device such as ICs, where patterns formed on substrates define functional elements of the devices, such as microprocessors, memory chips, etc. Similar lithographic techniques are also used in the formation of flat panel displays, micro-electro mechanical systems (MEMS) and other devices.

As semiconductor manufacturing processes continue to advance, the dimensions of functional elements have continually been reduced. At the same time, the number of functional elements, such as transistors, per device has been steadily increasing, following a trend commonly referred to as "Moore's law." At the current state of technology, layers of devices are manufactured using lithographic projection apparatuses that project a design layout onto a substrate using illumination from a deep-ultraviolet illumination source, creating individual functional elements having dimensions well below 100 nm, i.e. less than half the wavelength of the radiation from the illumination source (e.g., a 193 nm illumination source).

This process in which features with dimensions smaller than the classical resolution limit of a lithographic projection apparatus are printed, is commonly known as low-kl lithography, according to the resolution formula CD = $k1 \times \lambda/NA$, where $\lambda$ is the wavelength of radiation employed (currently in most cases 248nm or 193nm), NA is the numerical aperture of projection optics in the lithographic projection apparatus, CD is the "critical dimension"-generally the smallest feature size printed-and kl is an empirical resolution factor. In general, the smaller kl the more difficult it becomes to reproduce a pattern on the substrate that resembles the shape and dimensions planned by a designer in order to achieve particular electrical functionality and performance. To overcome these difficulties, sophisticated fine-tuning steps are applied to the lithographic projection apparatus, the design layout, or the patterning device. These include, for example, but not limited to, optimization of NA and optical coherence settings, customized illumination schemes, use of phase shifting patterning devices, optical proximity correction (OPC, sometimes also referred to as "optical and process correction") in the design layout, or other methods generally defined as "resolution enhancement techniques" (RET).

OPC and other RET utilize robust electronic models that describe the lithography process. Calibration procedures for such lithography models are thus desired that provide valid, robust and accurate models across the process window. Currently, calibration is done using a certain number of 1-dimensional and/or 2-dimensional gauge patterns with wafer measurements. More specifically, the 1-dimensional gauge patterns include line-space patterns with a varying pitch and critical dimension (CD), isolated lines, multiple lines, etc. The 2-dimensional gauge patterns typically include line-ends, contacts, and randomly selected SRAM (Static Random Access Memory) patterns.

## SUMMARY

Much of the context of the Summary and Detailed Description below is in the context of a high brightness electron source used for semiconductor inspection. However, this should not be considered limiting. There are other applications, such as brain imaging as one example, for the high brightness electron source described herein. As such, the principles described herein may be extended to other applications beyond semiconductor imaging.

According to an embodiment, there is provided a method for enhancing inspection throughput. The method comprises generating a plurality of pulsed constituent electron beams and combining the plurality of pulsed constituent electron beams into a combined electron inspection beam. The combined electron inspection beam has a greater brightness than each of the individual constituent pulsed electron beams. The combined electron inspection beam is configured for inspecting a substrate.

In an embodiment, the inspection throughput is a function of the brightness of the combined electron inspection beam. The greater brightness of the combined electron inspection beam enhances the inspection throughput.

In an embodiment, the combined electron inspection beam is aligned along a single optical axis.

In an embodiment, the inspection throughput is associated with a semiconductor manufacturing process, and the substrate is associated with a semiconductor device.

In an embodiment, pulses of electrons in different ones of the plurality of pulsed constituent electron beams are out of phase with each other such that the combined electron inspection beam is formed by a combination of the out of phase pulses of electrons.

In an embodiment, generating the plurality of pulsed constituent electron beams comprises: emitting a plurality of continuous beams of electrons; and causing energy spread in individual beams of the plurality of continuous beams to create pulses of electrons of similar energies in the individual beams to form the plurality of pulsed constituent electron beams.

In an embodiment, the plurality of pulsed constituent electron beams is combined into the combined electron inspection beam with a deflecting cavity.

In an embodiment, generating the plurality of pulsed constituent electron beams comprises emitting the plurality of pulsed constituent electron beams by a corresponding plurality of Schottky emitters or cold field emitters. In an embodiment, Schottky emitters are the most useful electron sources for semiconductor inspection. For other applications it is possible that, for example, thermal emitters are preferred as a starting point as they can deliver more current at lower brightness.

In an embodiment, the method further comprises accelerating the combined electron inspection beam to reduce effects of coulomb interactions.

In an embodiment, the method further comprises: dispersing electrons in the combined electron inspection beam by energy level such that electrons in the combined electron inspection beam having higher energy follow a relatively shorter path through a chicane, and electrons in the combined electron inspection beam having lower energy follow a relatively longer path through the chicane; and accelerating the combined electron inspection beam such that the electrons in the combined electron inspection beam having the lower energy gain more energy from the accelerating than the electrons in the combined electron inspection beam having the higher energy so as to reduce an energy spread between the lower energy electrons and the higher energy electrons.

In an embodiment, the inspection throughput is an inverse function of the energy spread, and reducing the energy spread further enhances the inspection throughput.

In an embodiment, dispersing electrons in the combined electron inspection beam by energy level comprises passing the combined electron inspection beam through a chicane comprising a plurality of magnetic deflectors. In an embodiment, the chicane comprises four magnetic deflectors.

In an embodiment, the accelerating is performed by an acceleration cavity.

In an embodiment, dispersing electrons in the combined electron inspection beam by energy level and accelerating the combined electron inspection beam produces monochromatic electron bunches.

In an embodiment, the inspection throughput is associated with bright field inspection or multi-beam inspection.

In an embodiment, inspection throughput is associated with a scanning electron microscope.

In an embodiment, the method further comprises: generating the combined electron inspection beam with a scanning electron microscope; and correcting a spherical aberration associated with the combined electron inspection beam with a multipole corrector. In an embodiment, the inspection throughput is a function of correcting the spherical aberration, such that correcting the spherical aberration further enhances the inspection throughput.

In an embodiment, the plurality of pulsed constituent electron beams comprises at least 10 pulsed constituent electron beams.

According to another embodiment, there is provided a method for enhancing inspection throughput. The method comprises passing an electron inspection beam through a curved path; dispersing the electron inspection beam by energy level as the electron inspection beam traverses the cured path such that electrons in the electron inspection beam having higher energy follow a relatively shorter path, and electrons in the electron inspection beam having lower energy follow a relatively longer path; and accelerating the electron inspection beam such that the electrons in the electron inspection beam having the lower energy gain more energy from the accelerating than the electrons in the electron inspection beam having the higher energy so as to reduce an energy spread between the lower energy electrons and the higher energy electrons. The accelerated electron inspection beam is configured for inspecting a substrate.

In an embodiment, the curved path comprises a chicane.

According to another embodiment, there is provided a method for enhancing inspection throughput. The method comprises generating an electron inspection beam with a scanning electron microscope; and correcting a spherical aberration associated with the electron inspection beam with a multipole corrector. The corrected electron inspection beam is configured for inspecting a substrate.

According to another embodiment, there is provided a computer program product comprising a non-transitory computer readable medium having instructions recorded thereon. The instructions, when executed by a computer, implement any or all of the operations described above.

According to another embodiment, there is provided an inspection system configured to enhance inspection throughput. The system comprises a plurality of emitters configured to generate a corresponding plurality of pulsed constituent electron beams; and an electron optical arrangement configured to combine the plurality of pulsed constituent electron beams into a combined electron inspection beam. The combined electron inspection beam has a greater brightness than each of the individual pulsed constituent electron beams. The combined electron inspection beam is configured to be used for inspecting a substrate.

In an embodiment, the electron optical arrangement comprises a deflecting cavity.

In an embodiment, the system further comprises a curved path configured to disperse the combined electron inspection beam by energy level such that electrons in the combined electron inspection beam having higher energy follow a relatively shorter path, and electrons in the combined electron inspection beam having lower energy follow a relatively longer path; and an accelerator configured to accelerate the combined electron inspection beam such that the electrons in the combined electron inspection beam having the lower energy gain more energy from the accelerating than the electrons in the combined electron inspection beam having the higher energy so as to reduce an energy spread between the lower energy electrons and the higher energy electrons.

In an embodiment, the curved path is a chicane. In an embodiment, the chicane comprises a plurality of magnetic deflectors.

In an embodiment, the accelerator comprises an accelerating cavity.

In an embodiment, the system further comprises a multipole corrector configured to correct a spherical aberration associated with the combined electron inspection beam. In an embodiment, the multipole corrector comprises at least one transfer lens, at least one adaptor lens, at least one alignment deflector, a beam tilt coil, a beam shift coil, and at least one stigmator.

In an embodiment, pulses of electrons in different ones of the plurality of pulsed constituent electron beams are out of phase with each other such that the combined electron inspection beam is formed by a combination of the out of phase pulses of electrons.

In an embodiment, the plurality of emitters comprises a plurality of Schottky emitters or cold field emitters.

In an embodiment, the inspection system is a scanning electron microscope.

According to another embodiment, there is provided an inspection system configured to enhance inspection throughput. The system comprises a curved path configured to disperse a combined electron inspection beam by energy level such that electrons in the combined electron inspection beam having higher energy follow a relatively shorter path, and electrons in the combined electron inspection beam having lower energy follow a relatively longer path. The system comprises an accelerator configured to accelerate the combined electron inspection beam such that the electrons in the combined electron inspection beam having the lower energy gain more energy from the accelerating than the electrons in the combined electron inspection beam having the higher energy so as to reduce an energy spread between the lower energy electrons and the higher energy electrons. The combined electron inspection beam is configured to be used for inspecting a substrate.

In an embodiment, the curved path is a chicane. In an embodiment, the chicane comprises a plurality of magnetic deflectors.

According to another embodiment, there is provided a scanning electron microscope inspection system configured to enhance inspection throughput. The system comprises a multipole corrector configured to correct a spherical aberration associated with a combined electron inspection beam. The combined electron inspection beam is configured to be used for inspecting a substrate.

In an embodiment, the multipole corrector comprises at least one transfer lens, at least one adaptor lens, at least one alignment deflector, a beam tilt coil, a beam shift coil, and at least one stigmator.

According to another embodiment, there is provided a high brightness electron source system. The system comprises a plurality of emitters configured to generate a corresponding plurality of pulsed constituent electron beams; and an electron optical arrangement configured to combine the plurality of pulsed constituent electron beams into a combined electron inspection beam. The combined electron inspection beam has a greater brightness than each of the individual pulsed constituent electron beams.

In an embodiment, the electron optical arrangement comprises a deflecting cavity.

In an embodiment, the system further comprises a curved path configured to disperse the combined electron inspection beam by energy level such that electrons in the combined electron inspection beam having higher energy follow a relatively shorter path, and electrons in the combined electron inspection beam having lower energy follow a relatively longer path; and an accelerator configured to accelerate the combined electron inspection beam such that the electrons in the combined electron inspection beam having the lower energy gain more energy from the accelerating than the electrons in the combined electron inspection beam having the higher energy so as to reduce an energy spread between the lower energy electrons and the higher energy electrons.

In an embodiment, the curved path is a chicane.

In an embodiment, the chicane comprises a plurality of magnetic deflectors.

In an embodiment, the accelerator comprises an accelerating cavity.

In an embodiment, the system further comprises a multipole corrector configured to correct a spherical aberration associated with the combined electron inspection beam.

In an embodiment, the multipole corrector comprises at least one transfer lens, at least one adaptor lens, at least one alignment deflector, a beam tilt coil, a beam shift coil, and at least one stigmator.

In an embodiment, pulses of electrons in different ones of the plurality of pulsed constituent electron beams are out of phase with each other such that the combined electron inspection beam is formed by a combination of the out of phase pulses of electrons.

In an embodiment, the plurality of emitters comprises a plurality of Schottky emitters or cold field emitters.

## BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:

Figure 1 illustrates a block diagram of various subsystems of a lithographic projection apparatus, according to an embodiment.

Figure 2 schematically depicts an embodiment of an electron beam inspection apparatus, according to an embodiment.

Figure 3 schematically illustrates another embodiment of an inspection apparatus, according to an embodiment.

Figure 4 illustrates an example method for enhancing inspection throughput, according to an embodiment.

Figure 5 illustrates an example of a Schottky emitter, according to an embodiment. It should be noted that when a buncher cavity is used (described herein), a continuous emission Schottky emitter can be used, for example.

Figure 6 illustrates an example of buncher cavities, according to an embodiment.

Figure 7 illustrates combining pulsed constituent electron beams into a combined electron inspection beam, according to an embodiment.

Figure 8 illustrates dispersing portions of the combined electron inspection beam by energy level, according to an embodiment.

Figure 9 illustrates an example of a multipole corrector, according to an embodiment.

Figure 10 illustrates performing an inspection with the combined electron inspection beam, according to an embodiment.

Figure 11 is a block diagram of an example computer system, according to an embodiment.

Figure 12 is a schematic diagram of a lithographic projection apparatus, according to an embodiment.

Figure 13 is a schematic diagram of another lithographic projection apparatus, according to an embodiment.

Figure 14 is a detailed view of a lithographic projection apparatus, according to an embodiment.

Figure 15 is a detailed view of the source collector module of a lithographic projection apparatus, according to an embodiment.

## DETAILED DESCRIPTION

Brightfield defect inspection as part of a semiconductor and/or integrated circuit manufacturing process is often performed with (beams of) light. Advantageously, light based inspection is a relatively fast process, and light based inspection throughput does not usually limit overall manufacturing output. However, it is more and more difficult to find ever smaller defects in manufactured semiconductor and/or other integrated circuit devices with light based inspection techniques. This is because the sizes of defects that can be detected with light based techniques are limited by the wavelengths of the light used during inspection.

Electron beam inspection techniques can be used as an alternative to light based inspection techniques. The inspection resolution of an electron beam is higher than that of a light beam because there is no wavelength associated with an electron beam (the effective wavelength of an electron beam is smaller than from a light beam) and electrons in the electron beam are small compared to the features of a semiconductor device and/or other integrated circuits. Thus, defects not detectable with light based techniques may be found with electron beam inspection techniques. However, past electron beam inspection techniques are slow compared to their light based counterparts. Slow throughput times often prevent use of prior electron beam inspection techniques.

To address these and other disadvantages of prior systems, the present electron beam based inspection systems and methods are configured such that more beam current (relative to prior electron beam based systems) is delivered to a substrate, while maintaining the increased resolution of an electron beam based inspection system (relative to light based systems). This, in turn, enhances inspection throughput. The present systems and methods are also configured to correct and/or otherwise decrease an energy spread in an electron inspection beam, and correct spherical aberration in the electron inspection beam. These operations also enhance inspection throughput. In these and other ways, the present systems and methods provide higher inspection throughput compared to prior electron beam based inspection systems, while also providing increased resolution compared to light based inspection. These example advantages are not intended to be limiting.

The present disclosure will now be described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of semiconductor devices and/or other integrated circuits (ICs), it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "projection optics," as used herein, should be broadly interpreted as encompassing various types of optical systems, including refractive optics, reflective optics, apertures and catadioptric optics, for example. The term "projection optics" may also include components operating according to any of these design types for directing, shaping or controlling the projection beam of radiation, collectively or singularly. The term "projection optics" may include any optical component in the lithographic projection apparatus, no matter where the optical component is located on an optical path of the lithographic projection apparatus. Projection optics may include optical components for shaping, adjusting and/or projecting radiation from the source before the radiation passes the (e.g., semiconductor) patterning device, and/or optical components for shaping, adjusting and/or projecting the radiation after the radiation passes the patterning device. The projection optics generally exclude the source and the patterning device.

The (e.g., semiconductor) patterning device can comprise, or can form, one or more design layouts. The design layout can be generated utilizing CAD (computer-aided design) programs, this process often being referred to as EDA (electronic design automation). Most CAD programs follow a set of predetermined design rules in order to create functional design layouts/patterning devices. These rules are set by processing and design limitations. For example, design rules define the space tolerance between devices (such as gates, capacitors, etc.) or interconnect lines, so as to ensure that the devices or lines do not interact with one another in an undesirable way. The design rules may include and/or specify specific parameters, limits on and/or ranges for parameters, and/or other information. One or more of the design rule limitations and/or parameters may be referred to as a "critical dimension" (CD). A critical dimension of a device can be defined as the smallest width of a line or hole or the smallest space between two lines or two holes, or other features. Thus, the CD determines the overall size and density of the designed device. One of the goals in device fabrication is to faithfully reproduce the original design intent on the substrate (via the patterning device).

The term "mask" or "patterning device" as employed in this text may be broadly interpreted as referring to a generic semiconductor patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include a programmable mirror array and a programmable LCD array.

An example of a programmable mirror array can be a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind; in this manner, the beam becomes patterned according to the addressing pattern of the matrix-addressable surface. The required matrix addressing can be performed using suitable electronic means. An example of a programmable LCD array is given in U.S. Patent No. 5,229,872, which is incorporated herein by reference.

As used herein, the term "patterning process" generally means a process that creates an etched substrate by the application of specified patterns of light as part of a lithography process. However, "patterning process" can also include plasma etching, as many of the features described herein can provide benefits to forming printed patterns using plasma processing.

As used herein, the term "target pattern" means an idealized pattern that is to be etched on a substrate.

As used herein, the term "printed pattern" means the physical pattern on a substrate that was etched based on a target pattern. The printed pattern can include, for example, troughs, channels, depressions, edges, or other two and three dimensional features resulting from a lithography process.

As used herein, the term "prediction model" and/or "process model" (which may be used interchangeably) means a model that includes one or more models that simulate a patterning process. For example, a prediction and/or process model can include an optical model (e.g., that models a lens system/projection system used to deliver light in a lithography process and may include modelling the final optical image of light that goes onto a photoresist), a resist model (e.g., that models physical effects of the resist, such as chemical effects due to the light), and an OPC model (e.g., that can be used to make target patterns and may include sub-resolution resist features (SRAFs), etc.), and/or other models.

As used herein, the term "calibrating" means to modify (e.g., improve or tune) and/or validate something, such as the process model.

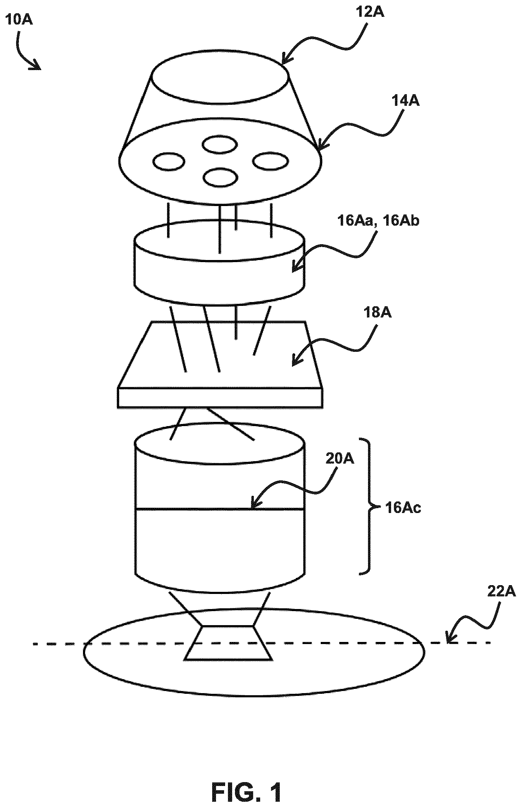

As an introduction, Figure 1 illustrates a diagram of various subsystems of an example lithographic projection apparatus 10A. Major components are a radiation source 12A, which may be a deep-ultraviolet excimer laser source or other type of source including an extreme ultra violet (EUV) source (as discussed above, the lithographic projection apparatus itself need not have the radiation source), illumination optics which, for example, define the partial coherence (denoted as sigma) and which may include optics 14A, 16Aa and 16Ab that shape radiation from the source 12A; a patterning device 18A; and transmission optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics $NA = n \sin(\Theta_{max})$, wherein n is the refractive index of the media between the substrate and the last element of the projection optics, and $\Theta_{max}$ is the largest angle of the beam exiting from the projection optics that can still impinge on the substrate plane 22A.

In a lithographic projection apparatus, a source provides illumination (i.e. radiation) to a patterning device and projection optics direct and shape the illumination, via the patterning device, onto a substrate. The projection optics may include at least some of the components 14A, 16Aa, 16Ab and 16Ac. An aerial image (AI) is the radiation intensity distribution at substrate level. A resist model can be used to calculate the resist image from the aerial image, an example of which can be found in U.S. Patent Application Publication No. US 2009-0157630, the disclosure of which is hereby incorporated by reference in its entirety. The resist model is related to properties of the resist layer (e.g., effects of chemical processes which occur during exposure, post-exposure bake (PEB) and development). Optical properties of the lithographic projection apparatus (e.g., properties of the illumination, the patterning device and the projection optics) dictate the aerial image and can be defined in an optical model. Since the patterning device used in the lithographic projection apparatus can be changed, it is desirable to separate the optical properties of the patterning device from the optical properties of the rest of the lithographic projection apparatus including at least the source and the projection optics. Details of techniques and models used to transform a design layout into various lithographic images (e.g., an aerial image, a resist image, etc.), apply OPC using those techniques and models and evaluate performance (e.g., in terms of process window) are described in U.S. Patent Application Publication Nos. US 2008-0301620, 2007-0050749, 2007-0031745, 2008-0309897, 2010-0162197, and 2010-0180251, the disclosure of each which is hereby incorporated by reference in its entirety.

It may be desirable to use one or more tools to produce results that, for example, can be used to design, control, monitor, etc. the patterning process. One or more tools used in computationally controlling, designing, etc. one or more aspects of the patterning process, such as the pattern design for a patterning device (including, for example, adding sub-resolution assist features or optical proximity corrections), the illumination for the patterning device, etc., may be provided. Accordingly, in a system for computationally controlling, designing, etc. a manufacturing process involving patterning, the manufacturing system components and/or processes can be described by various functional modules and/or models. In some embodiments, one or more electronic (e.g., mathematical, parameterized, etc.) models may be provided that describe one or more steps and/or apparatuses of the patterning process. In some embodiments, a simulation of the patterning process can be performed using one or more electronic models to simulate how the patterning process forms a patterned substrate using a design pattern provided by a patterning device.

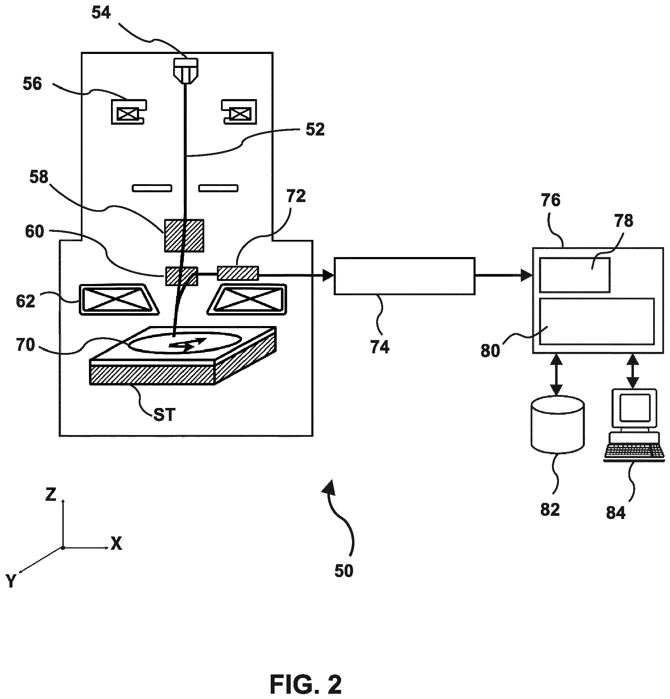

Fabricated devices may be inspected at various points during manufacturing. Figure 2 schematically depicts a generalized embodiment of an electron beam inspection apparatus 50. In some embodiments, the inspection apparatus may be an electron beam inspection apparatus (e.g., the same as or similar to a scanning electron microscope (SEM)) that yields an image of a structure (e.g., some or all the structure of a device, such as an integrated circuit) exposed or transferred on a substrate. A primary electron beam 52 emitted from an electron source 54 is converged by condenser lens 56 and then passes through a beam deflector 58, an E x B deflector 60, and an objective lens 62 to irradiate a substrate 70 on a substrate table ST at a focus.

When the substrate 70 is irradiated with electron beam 52, secondary electrons are generated from the substrate 70. The secondary electrons are deflected by the E x B deflector 60 and detected by a secondary electron detector 72. A two-dimensional electron beam image can be obtained by detecting the electrons generated from the sample in synchronization with, e.g., two dimensional scanning of the electron beam by beam deflector 58 or with repetitive scanning of electron beam 52 by beam deflector 58 in an X or Y direction, together with continuous movement of the substrate 70 by the substrate table ST in the other of the X or Y direction. Thus, in an embodiment, the electron beam inspection apparatus has a field of view for the electron beam defined by the angular range into which the electron beam can be provided by the electron beam inspection apparatus (e.g., the angular range through which the deflector 60 can provide the electron beam 52). Thus, the spatial extent of the field of the view is the spatial extent to which the angular range of the electron beam can impinge on a surface (wherein the surface can be stationary or can move with respect to the field).

As shown in Figure 2, a signal detected by secondary electron detector 72 may be converted to a digital signal by an analog/digital (A/D) converter 74, and the digital signal may be sent to an image processing system 76. In an embodiment, the image processing system 76 may have memory 78 to store all or part of digital images for processing by a processing unit 80. The processing unit 80 (e.g., specially designed hardware or a combination of hardware and software or a computer readable medium comprising software) is configured to convert or process the digital images into datasets representative of the digital images. In an embodiment, the processing unit 80 is configured or programmed to cause execution of an operation (e.g., SEM inspection) described herein. Further, image processing system 76 may have a storage medium 82 configured to store the digital images and corresponding datasets in a reference database. A display device 84 may be connected with the image processing system 76, so that an operator can conduct necessary operation of the equipment with the help of a graphical user interface.

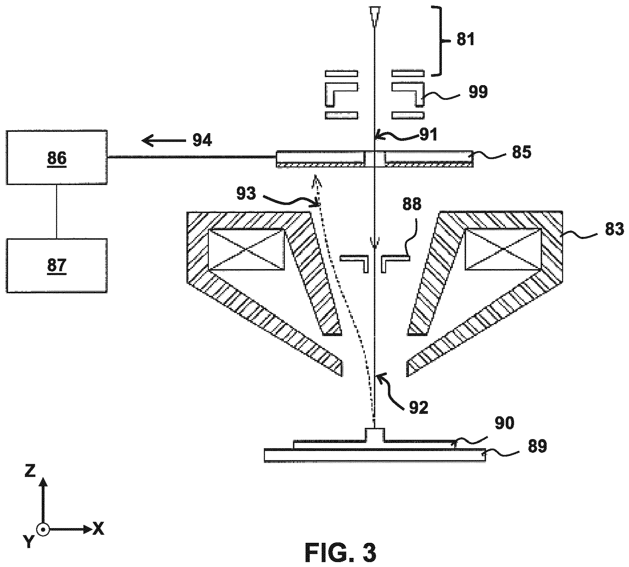

Figure 3 schematically illustrates another embodiment of an inspection apparatus. The system is used to inspect a sample 90 (such as a substrate) on a sample stage 89 and comprises a charged particle beam generator 81, a condenser lens module 99, a probe forming objective lens module 83, a charged particle beam deflection module 88, a secondary charged particle detector module 85, an image forming module 86, and/or other components. The charged particle beam generator 81 generates a primary charged particle beam 91. The condenser lens module 99 condenses the generated primary charged particle beam 91. The probe forming objective lens module 83 focuses the condensed primary charged particle beam into a charged particle beam probe 92. The charged particle beam deflection module 88 scans the formed charged particle beam probe 92 across the surface of an area of interest on the sample 90 secured on the sample stage 89. In some embodiments, the charged particle beam generator 81, the condenser lens module 83, and the probe forming objective lens module 83, or their equivalent designs, alternatives or any combination thereof, together form a charged particle beam probe generator which generates the scanning charged particle beam probe 92.

The secondary charged particle detector module 85 detects secondary charged particles 93 emitted from the sample surface (maybe also along with other reflected or scattered charged particles from the sample surface) upon being bombarded by the charged particle beam probe 92 to generate a secondary charged particle detection signal 94. The image forming module 86 (e.g., a computing device) is coupled with the secondary charged particle detector module 85 to receive the secondary charged particle detection signal 94 from the secondary charged particle detector module 85 and accordingly form at least one scanned image. In an embodiment, the secondary charged particle detector module 85 and image forming module 86, or their equivalent designs, alternatives or any combination thereof, together form an image forming apparatus which forms a scanned image from detected secondary charged particles emitted from sample 90 being bombarded by the charged particle beam probe 92.

In an embodiment, a monitoring module 87 is coupled to the image forming module 86 of the image forming apparatus to monitor, control, etc. the patterning process and/or derive a parameter for patterning process design, control, monitoring, etc. using the scanned image of the sample 90 received from image forming module 86. In some embodiments, the monitoring module 87 is configured or programmed to cause execution of an operation described herein. In some embodiments, the monitoring module 87 comprises a computing device. In some embodiments, the monitoring module 87 comprises a computer program configured to provide functionality described herein. In some embodiments, a probe spot size of the electron beam in the system of Figure 3 is significantly larger compared to, e.g., a CD, such that the probe spot is large enough so that the inspection speed can be fast. However, the resolution may be lower because of the large probe spot.

Images, from, e.g., the system of Figure 2 and/or Fig. 3, may be processed to extract dimensions, shapes, contours, and/or other information that describe the edges of objects, representing semiconductor device structures, in the image. The shapes, contours, and/or other information may be quantified via metrics, such as CD, at user-defined cut-lines and/or in other locations. In some embodiments, the images of device structures are compared and quantified via metrics, such as an edge-to-edge distance (CD) measured on extracted contours or simple pixel differences between images. Alternatively, metrics can include EP gauges and/or other parameters.

As described above, the present electron beam based inspection systems and methods are configured such that more beam current (relative to prior electron beam based systems) is delivered to a substrate, while maintaining the increased resolution of an electron beam based inspection system (relative to light based systems). This in turn, enhances throughput. The present systems and methods are also configured to correct and/or otherwise decrease an energy spread in an electron inspection beam, and correct spherical aberration in the electron inspection beam. These operations also enhance throughput. In these and other ways, the present systems and methods provide higher inspection throughput compared to prior electron beam based inspection systems, while also providing increased resolution compared to light based inspection.

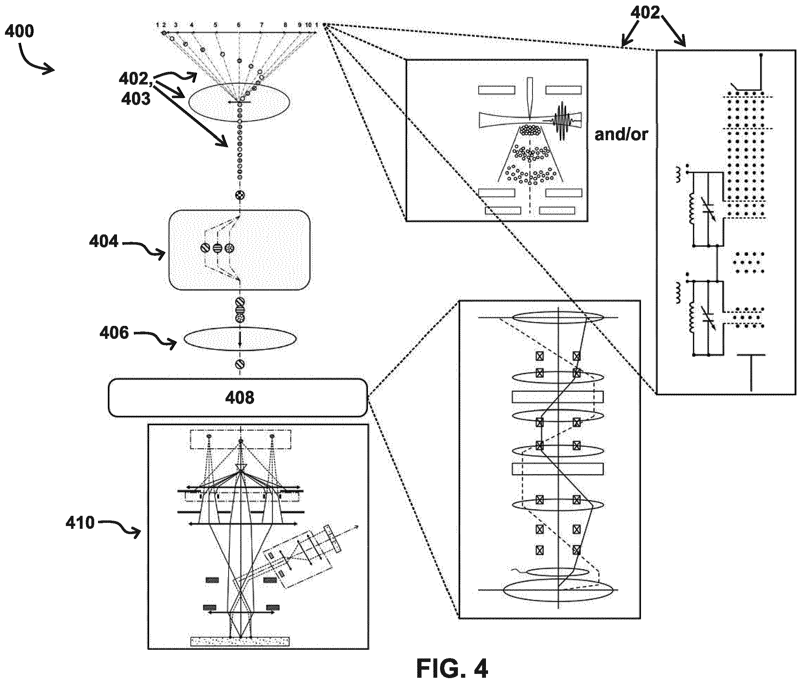

Figure 4 illustrates an example method 400 according to one or more embodiments. Method 400 may be a method for enhancing inspection throughput. In some embodiments, the inspection throughput is associated with bright field inspection or multi-beam inspection, for example. In some embodiments, the inspection throughput is associated with a scanning electron microscope, the system of Figure 2 and/or Figure 3, and/or other systems. In some embodiments, one or more operations of method 400 described below may be performed in or by one or more components of a scanning electron microscope. In some embodiments, the scanning electron microscope may form an inspection system such as the ones described in Figures 2 and/or 3 and/or other inspection systems, for example. In some embodiments, the operations of method 400 are performed for a semiconductor manufacturing process, for example. In some embodiments, the inspection throughput is associated with the semiconductor manufacturing process, and the inspection is performed on one or more substrates. The one or more substrates may be associated with a semiconductor device, and/or other integrated circuits, for example.

As shown in Figure 4, method 400 may include generating 402 pulsed constituent electron beams, combining 403 the pulsed constituent electron beams into a combined beam, dispersing 404 portions of the combined beam by energy level, accelerating 406 the combined beam, correcting 408 a spherical aberration of the combined beam, performing 410 inspection with the combined beam, and/or other operations. These operations are described in more detail below.

The operations of method 400 presented below are intended to be illustrative. In some embodiments, method 400 may be accomplished with one or more additional operations not described, and/or without one or more of the operations discussed. Additionally, the order in which the operations of method 400 are illustrated in FIG. 4 and described below is not intended to be limiting.

In some embodiments, one or more portions of method 400 may be implemented (e.g., by simulation, modeling, electronically controlling one or more components of a scanning electron microscope, etc.) in one or more processing devices. The one or more processing devices may include one or more devices executing some or all of the operations of method 400 in response to instructions stored electronically on an electronic storage medium. The one or more processing devices may include one or more devices configured through hardware, firmware, and/or software to be specifically designed for execution of one or more of the operations of method 400, for example.

Throughput associated with an electron beam inspection system is limited by the system electron inspection beam current, which is the product of the electron current in an individual beamlet and the number of beamlets (combined to form the electron inspection beam) in the system. Some systems are limited in the number of beamlets they can provide, so throughput cannot be enhanced by simply adding more beamlets. Such systems may be limited in this way because a field size at a substrate (undergoing inspection) is limited due to field aberrations that can only be compensated for to a certain extent by an aperture plate. The beamlets at the aperture plate have to be separated to allow for space for the field aberration correcting elements in the aperture plate, for example.

As an alternative to simply adding more beamlets (which is often not possible as described above), properties of existing beamlets may be enhanced. For example, the current in a beamlet is determined by an electron source brightness, beam aberrations, a coulomb interaction, and other factors according to the following equation:

$$I = B_r.V.\alpha^2.\left[d_{spot}{}^2 - [C_s.\alpha^3]^2 - \left[C_c.\alpha.\frac{\Delta V}{V}\right]^2\right]$$

In this equation, I is current in an individual beamlet, $B_r$ is the source brightness, $C_s$ is an spherical aberration coefficient, $C_c$ is an aberration coefficient associated with chromatic aberration, V is beam energy, $\alpha$ is the opening angle of the beam at the substrate, $d_{spot}$ is the diameter of the beamlet, and $\Delta V$ is the beamlet's energy spread. As the equation makes clear, increasing brightness, correcting spherical aberration, correcting the chromatic aberration, decreasing the energy spread, and/or other operations enhance the current (of the beamlet and the overall system electron inspection beam), and in turn enhances inspection throughput. The variable $d_{spot}$ is associated with the application, i.e., for inspection defects of size x, one needs an optical resolution y where the ratio x/y is constant. V is limited as higher energy results in more damaging impact on the substrate. $C_c$ can be corrected much the same as $C_s$ (as described herein) and this is an alternative to reducing $\Delta V$. The operations of method 400 described below are configured to increase a brightness of the electron inspection beam, decrease an energy spread in the electron inspection beam, correct a spherical aberration associated with the electron inspection beam, and/or have other effects which increase the system beam current (and thus enhance throughput).

For example, for inspection at a 2nm node, a 1000 mm$^2$ /hour throughput requires a total beam current of 9 $\mu$A at the substrate level. This would require 9000 beamlets in a prior system, which does not fit the current 100-400 beamlet maximum for such systems. In contrast, for the same requirements, the present system(s) and/or methods facilitate use of only 121 (i.e., 11x11 beamlets), which does fit within the current 100-400 beamlet system designs. (In this example, with the present systems and methods, forty sources (as described below) may be combined and an associated energy spread and Cs are reduced by 50%).

Brightness (e.g., $B_r$ in the equation above) may be enhanced by adding multiple sources together to create a new source with the same emittance (area times solid angle of emission), while the total current is the sum of all sources. In some embodiments, operation 402, 403, and/or other operations may facilitate enhancing source brightness.

Method 400 includes generating 402 a plurality of pulsed constituent electron beams. In some embodiments, the plurality of pulsed constituent electron beams comprises at least 2, 5, 10, or more pulsed constituent electron beams. In some embodiments, pulses of electrons in different ones of the plurality of pulsed constituent electron beams are out of phase with each other.

For example, in some embodiments, generating the plurality of pulsed constituent electron beams comprises emitting a plurality of continuous beams of electrons; and causing energy spread in individual beams of the plurality of continuous beams to create pulses of electrons of similar energies in the individual beams to form the plurality of pulsed constituent electron beams. The plurality of pulsed constituent electron beams may be generated by a corresponding number of emitters, for example. The emitters may be included in and/or associated with a scanning electron microscope, for example, and/or other systems. In some embodiments, generating the plurality of pulsed constituent electron beams comprises emitting the plurality of pulsed constituent electron beams by a corresponding plurality of Schottky emitters or cold field emitters, and then causing energy spread in individual beams of the plurality of continuous beams (e.g., with buncher cavities and/or other components) to create pulses of electrons of similar energies in the individual beams to form the plurality of pulsed constituent electron beams.

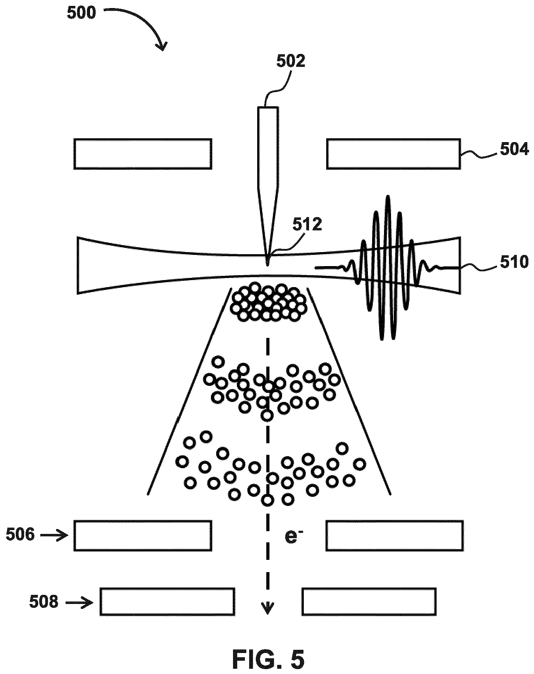

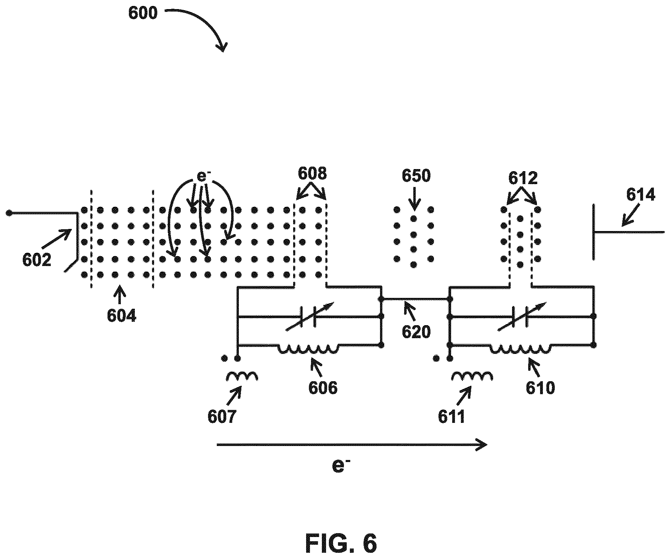

This is illustrated in Figures 5 and 6. Figure 5 illustrates an example of a Schottky emitter 500. A Schottky emitter may be advantageous because it is associated with relatively high brightness, and relative stability, compared to other emitters. Emitter 500 includes an electron source needle 502, a suppressor 504, an extractor 506, and a focus anode 508. As shown in Figure 5, energy 510 (e.g., a laser) is focused on a tip 512 of electron source needle 502, which gives off electrons (e⁻) responsive to absorbing at least some of energy 510. Suppressor 504 is configured to concentrate the field strength on the tip of the needle. Extractor 506 is configured to pull away emitted electrons from the tip of the needle. Focus anode 508 is configured to focus the extracted electrons. Figure 5 illustrates a pulsed Schottky emitter. It should be noted that when a buncher cavity is used, a continuous emission Schottky emitter can be used, for example. The present disclosure is intended to cover both embodiments. Also, in some embodiments, Schottky emitters are the most useful electron sources for semiconductor inspection. For other applications it is possible that, for example, thermal emitters are preferred as a starting point as they can deliver more current at lower brightness.

Figure 6 illustrates an example of buncher cavities 600. Buncher cavities 600 are configured to cause energy spread in an individual electron beam (e.g., the beam of electrons shown in Figure 5) to create pulses of electrons of similar energies in the individual beams to form the plurality of pulsed constituent electron beams. Buncher cavities 600 may include an electron source 602 (e.g., which may be similar to and/or the same as emitter 500 shown in Figure 5), an accelerator 604, a first resonant cavity 606 (having an input 607) that forms a buncher 608, a second resonant cavity 610 (having an output 611) that forms a catcher 612, and a collector 614. Accelerator 604 may be configured to accelerate the electrons in the beam of electrons to reduce the effects of coulomb interactions, for example. Coulomb interaction is the effect that electrons repel each other as they are all negatively charged. The result is blurring of the spot: it enlarges the probe size much the same as aberrations do. The effect is more severe when the electron density is higher (I) or when they travel slower (V). Collector 614 may be an anode plate for example, and/or be formed by other components. In some embodiments, the anode may have a hole in the center such that electrons can pass on their way to a substrate. In some embodiments, there may be a feedback path 620 between cavity 610 and cavity 606. As shown in Figure 6, buncher 608 is configured to generate groups 650 of bunched (or pulsed) electrons. For example, speed variation in individual electrons may be introduce by time varying acceleration in buncher cavities 600. After a drift space the electrons are grouped in bunches. Potentially stray electrons may be blocked by second cavity 610. In some embodiments, the cavity is a "box" in which a radio frequent electrical field is generated. The orientation of the field is such that it alternates in the same direction the stream of electrons is passing the "box". Those electrons that are in the box at the moment that the field strength is maximally pointing forward, will get extra energy so they will travel faster than the average. Those electrons that are in the box at the moment that the field strength is maximally pointing backward, will get lower energy so they will travel slower than the average. Speed variation between the electrons will result in bunching.

In some embodiments, a plurality of Schottky emitters (e.g., 500 shown in Figure 5) and/or corresponding buncher cavities (e.g., 600 shown in Figure 6) are used to generate a plurality of separate pulsed constituent electron beams. In some embodiments, as described above, the plurality of pulsed constituent electron beams comprises at least 2, 5, 10, or more pulsed constituent electron beams. This means that there may be 2, 5, 10 or more sets of Schottky emitters and/or buncher cavities, for example. In some embodiments, the separate pulsed constituent electron beams may have frequencies of about 130MHz, for example. Bunches having a duration of about 10pc can be created with about a 7.7ns spacing at this frequency. These examples are not intended to be limiting. In some embodiments, the Schottky emitter and/or buncher cavities are configured such that the pulses of electrons in different ones of the plurality of pulsed constituent electron beams are out of phase with each other. For example, the pulses of electrons in the different ones of the plurality of pulsed constituent electron beams have a timing that does not match the timing of other pulses of electrons in other beams. This is realized by proper phasing of the RF field in the buncher cavities associated to the various beams.

It should be noted that, in some embodiments, buncher cavities 600 may not be necessary. Instead, for example, the energy (e.g., the laser) directed at the tip (e.g., 512) of the electron source needle (e.g., 502) shown in Figure 5 may be pulsed to create a pulsed flow of electrons in an electron beam from a given source.

Returning to Figure 4, method 400 includes combining 403 the pulsed constituent electron beams into a combined electron inspection beam. The combined electron inspection beam is formed by a combination of the out of phase pulses of electrons. The combined electron inspection beam has a greater brightness than each of the individual constituent pulsed electron beams. As described above, the inspection throughput is a function of the brightness of the combined electron inspection beam. The greater brightness of the combined electron inspection beam enhances the inspection throughput. For example, since $B_r$ is positive and appears on the right hand side of the equation shown above, any increase in brightness produces a corresponding increase in current (I). As described above, increasing current enhances inspection throughput.

The combined electron inspection beam may be configured for inspecting a substrate and/or other objects. For example, the combined electron inspection beam may be a scanning electron microscope inspection beam. The substrate may be part of a semiconductor device, for example, and/or other substrates. In some embodiments, the plurality of pulsed constituent electron beams is combined into the combined electron inspection beam with an electron optical arrangement and/or other components. The electron optical arrangement may comprise a deflecting cavity, for example, and/or other devices.

A buncher cavity was described above. A deflecting cavity differs in the sense that the electrons travel through the box perpendicular to the direction of the RF electrical field. The result is that the defecting will differ as function of time. In some embodiments, the combined electron inspection beam is aligned along a single optical axis.

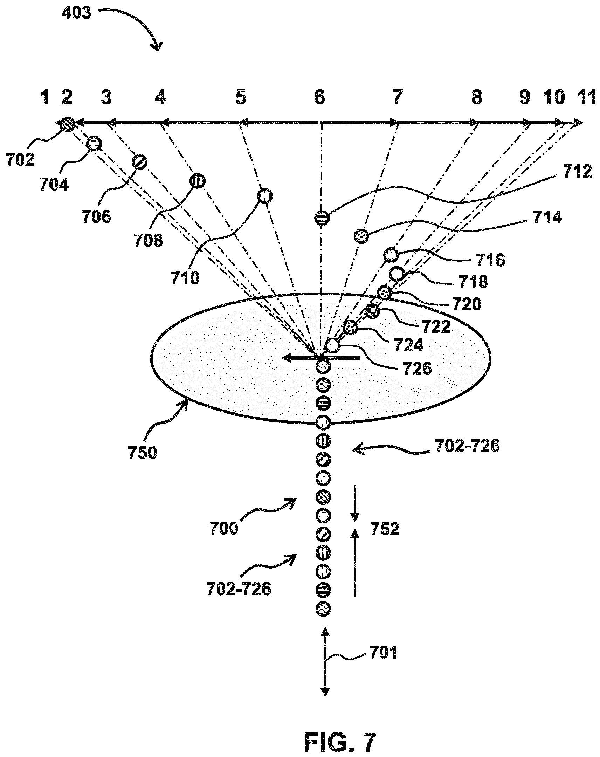

Figure 7 illustrates combining 403 pulsed constituent electron beams 1-11 into a combined electron inspection beam 700. Combined electron inspection beam 700 is oriented along a single optical axis 701, for example. As shown in Figure 7, combined electron inspection beam 700 is formed by a combination of the out of phase pulses 702-726 of electrons. In this example, once combined, the pulses 702-726 of electrons may have a spacing 752 of about 0.77ns (which corresponds to a frequency of 1.3GHz). This is an example only. Combined electron inspection beam 700 has a greater brightness than each of the individual constituent pulsed electron beams 1-11. In some embodiments, the plurality of pulsed constituent electron beams 1-11 are combined into combined electron inspection beam 700 with an electron optical arrangement and/or other components. The electron optical arrangement may comprise a deflecting cavity 750, for example, and/or other devices.

Returning to Figure 4, according to the equation above, reducing the energy spread (e.g., $\Delta V$ in the equation above) in the combined electron inspection beam (e.g., 700 shown in Figure 7) also increases the current (I) and thus enhances inspection throughput. For example, the inspection throughput is an inverse function of the energy spread, and reducing the energy spread further enhances the inspection throughput. In some embodiments, operations 404, 406, and/or other operations may facilitate reducing the energy spread in the combined electron inspection beam.

Method 400 includes dispersing 404 portions of the combined electron inspection beam by energy level. Dispersing 404 electrons in the combined electron inspection beam by energy level may comprise passing the electrons through a curved path and/or other dispersal operations. The curved path may be a chicane, for example, and/or other devices configured to disperse electrons in an electron beam by energy level. In some embodiments, dispersing electrons in the combined electron inspection beam by energy level comprises passing the combined electron inspection beam through a chicane comprising a plurality of magnetic deflectors. In some embodiments, the chicane comprises two, three, four, or more magnetic deflectors. In some embodiments, the electrons in the combined electron inspection beam are dispersed by energy level such that electrons in the combined electron inspection beam having higher energy follow a relatively shorter path through the chicane, and electrons in the combined electron inspection beam having lower energy follow a relatively longer path through the chicane. After the chicane, the electrons form bunches based on their energy levels.

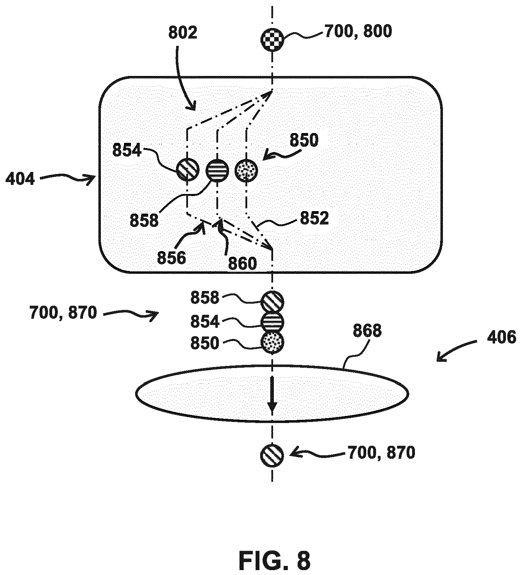

By way of a non-limiting example, Figure 8 illustrates dispersing 404 portions 800 of combined electron inspection beam 700 by energy level. A portion 800 of the combined electron inspection beam 700 may be an electron bunch having energy spread, for example. Electrons in portion 800 may pass through a curved path 802, for example. Curved path 802 may be a chicane, for example, and/or other devices configured to disperse electrons in an electron beam by energy level. The chicane may include and/or be formed by a plurality of magnetic deflectors. In this example, the chicane may be formed by four magnetic deflectors, but this is not intended to be limiting. In some embodiments, the electrons in portion 800 are dispersed by energy level such that electrons 850 in portion 800 having higher energy follow a relatively shorter path 852 through the chicane, and electrons 854 in portion 800 having lower energy follow a relatively longer path 856 through the chicane. (One or more other groups of electrons 858 may also follow one or more other paths 860 through the chicane). After the chicane, the electrons form bunches based on their energy levels. In this example, electrons 850, 854, and 858 are shown longitudinally separated 870.

Returning to Figure 4, method 400 includes accelerating 406 the combined electron inspection beam (e.g., 700 shown in Figure 7). The combined electron inspection beam may be accelerated to reduce effects of coulomb interactions, and/or for other reasons. Accelerating 406 the combined electron inspection beam is configured such that the electrons in the combined electron inspection beam having the lower energy gain more energy from the accelerating than the electrons in the combined electron inspection beam having the higher energy so as to reduce an energy spread between the lower energy electrons and the higher energy electrons. Put another way, the electrons in the combined electron inspection beam may be accelerated off-crest, meaning that the lower energy electrons in a given bunch of electrons receive more energy than the higher energy electrons in the bunch. The result is less variation in energy between the electrons in the bunch. In some embodiments, dispersing electrons in the combined electron inspection beam by energy level and accelerating the combined electron inspection beam produces monochromatic electron bunches.

In some embodiments, the acceleration may be performed by an accelerating cavity and/or other components. In some embodiments, speed variation in individual electrons may be introduce by time varying acceleration. In some embodiments, the acceleration is provided either with a cavity or with a DC electrical field provided by an electrode much the same as the extractor in the Schottky source. The acceleration cavity may include and/or be formed by a box with an RF field, where the electrons travel through the box. As they are bunched, the electrons in a bunch will get the same "kick" from the electrical field. When the frequency of bunches matches the frequency of the RF field the bunches will be accelerated equally.

By way of a non-limiting example, Figure 8 also illustrates accelerating 406 combined electron inspection beam 700. Accelerating combined electron inspection beam 700 is performed with an accelerating cavity 868 in this example.

Accelerating 406 combined electron inspection beam 700 is configured such that the electrons in combined electron inspection beam 700 having the lower energy (e.g., 858) gain more energy from the accelerating than the electrons in the combined electron inspection beam having the higher energy (e.g., 850) so as to reduce an energy spread between the lower energy electrons and the higher energy electrons. In some embodiments, dispersing electrons in the combined electron inspection beam by energy level and accelerating the combined electron inspection beam produces monochromatic electron bunches 870.

Returning to Figure 4, in some embodiments, method 400 includes correcting 408 a spherical aberration (e.g., $C_s$ in the equation above) of the combined beam. In some embodiments, for example, method 400 includes generating the combined electron inspection beam (e.g., according to the operations described above) with a scanning electron microscope; and correcting a spherical aberration associated with the combined electron inspection beam. In some embodiments, the inspection throughput is a function of correcting the spherical aberration (e.g., as shown in the equation above), such that correcting the spherical aberration further enhances the current (I) and the inspection throughput.

The spherical aberration may be corrected with a multipole corrector, and/or other devices. The multipole corrector may be a series of lenses, deflectors, magnetic coils, and/or other components configured to correct aberrations in the combined electron inspection beam. In some embodiments, the multipole corrector comprises at least one transfer lens, at least one adaptor lens, at least one alignment deflector, a beam tilt coil, a beam shift coil, at least one stigmator, and/or other components.

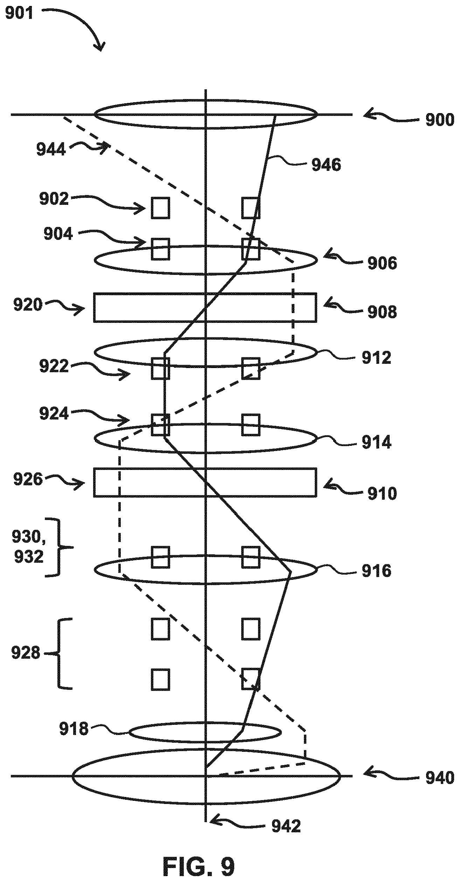

For example, Figure 9 illustrates an example of a multipole corrector 901. In the example shown in Figure 9, the multipole corrector comprises a hexapole corrector, but other types of multipole correctors are contemplated. As shown in Figure 9, multipole corrector 901 comprises a condenser lens 900, a beam tilt coil 902, a beam shift coil 904, an adaptor lens 906, hexapole elements 908 and 910, transfer lenses 912, 914, 916, and 918, alignment deflectors 920, 922, 924, 926, and 928, stigmators 930 and 932, and other components. Figure 9 also illustrates a specimen plane 940, a beam 942, an axial ray 944, and a field ray 946 between condenser lens 900 and specimen plane 940. In some embodiments, beam 942 may be similar to and/or the same as combined electron inspection beam 700 shown in prior figures.

Returning to Figure 4, in some embodiments, method 400 includes performing 410 inspection with the combined electron inspection beam (e.g., 700 shown in Figure 7). Performing 410 inspection with the combined electron inspection beam is configured to enhance inspection throughput. As described above, in some embodiments, the inspection throughput is associated with bright field inspection or multi-beam inspection, for example. In some embodiments, the inspection throughput is associated with a scanning electron microscope, and/or other systems. In some embodiments, operation 410 may be performed for a semiconductor and/or other integrated circuit manufacturing process, for example. In some embodiments, the inspection throughput is associated with the semiconductor manufacturing process, and the inspection is performed on one or more substrates. The one or more substrates may be associated with a semiconductor device, and/or other integrated circuits, for example.

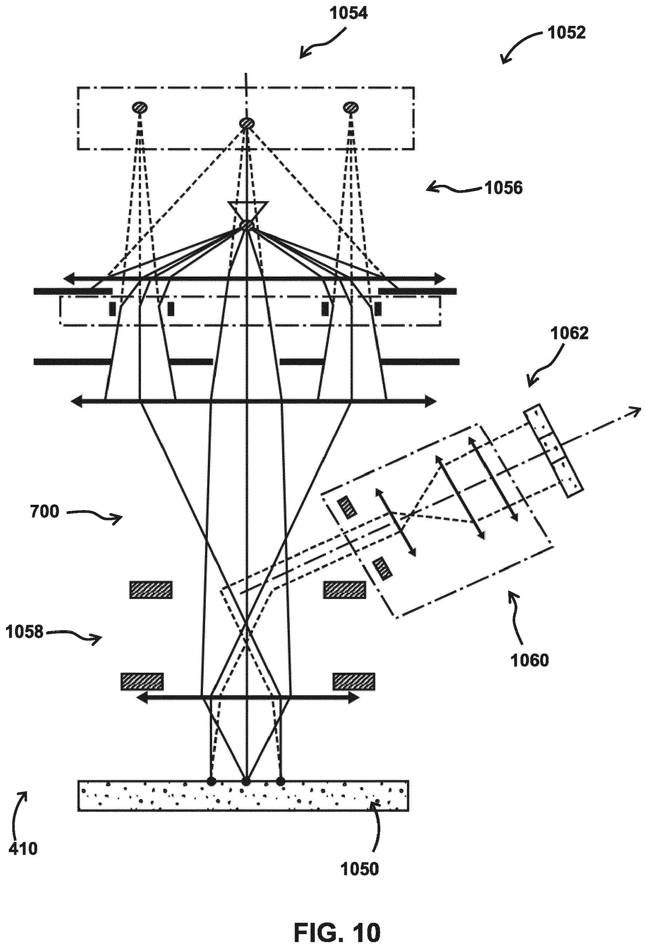

For example, Figure 10 illustrates performing 410 an inspection of a sample 1050 with the combined electron inspection beam 700. Figure 10 illustrates an example multibeam inspection system 1052. Multibeam inspection system 1052 may comprise a source 1054, a source multiplier 1056, a first projection system 1058, a second projection system 1060, a detector 1062, and/or other components. Performing 410 inspection with combined electron inspection beam 700 and system 1052 is configured to enhance inspection throughput for inspection of samples 1050. As described above, in some embodiments, the inspection throughput is associated with bright field inspection instead of multi-beam inspection as shown here. In some embodiments, system 1052 may be used for a semiconductor and/or other integrated circuit manufacturing process inspection, for example. In some embodiments, the inspection throughput is associated with the semiconductor manufacturing process, and the inspection is performed on one or more substrates such as sample 1050. Samples 1050 may be associated with a semiconductor device, and/or other integrated circuits, for example. It should be noted that Figure 10 is an example only, and is representative of the ability to interface the high brightness electron source described herein with a number of different electron beam systems.

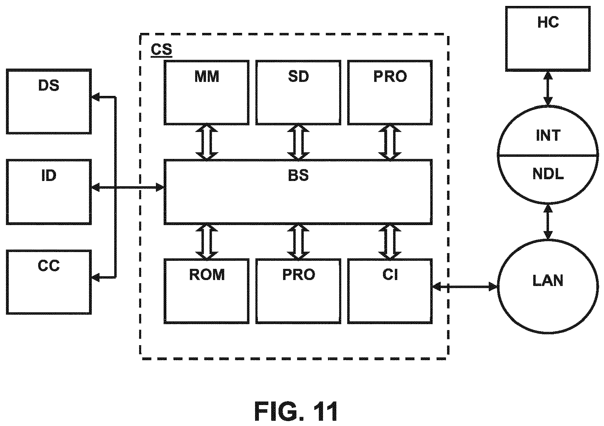

Figure 11 is a diagram of an example computer system CS that may be used for one or more of the operations described herein. Computer system CS includes a bus BS or other communication mechanism for communicating information, and a processor PRO (or multiple processors) coupled with bus BS for processing information. Computer system CS also includes a main memory MM, such as a random access memory (RAM) or other dynamic storage device, coupled to bus BS for storing information and instructions to be executed by processor PRO. Main memory MM also may be used for storing temporary variables or other intermediate information during execution of instructions by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

In some embodiments, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions included in main memory MM causes processor PRO to perform the process steps (operations) described herein. One or more processors in a multi-processing arrangement may also be employed to execute the sequences of instructions contained in main memory MM. In some embodiments, hard-wired circuitry may be used in place of or in combination with software instructions. Thus, the description herein is not limited to any specific combination of hardware circuitry and software.

The term "computer-readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the operations described herein. Transitory computer-readable media can include a carrier wave or other propagating electromagnetic signal, for example.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) may use electrical, electromagnetic or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN, and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

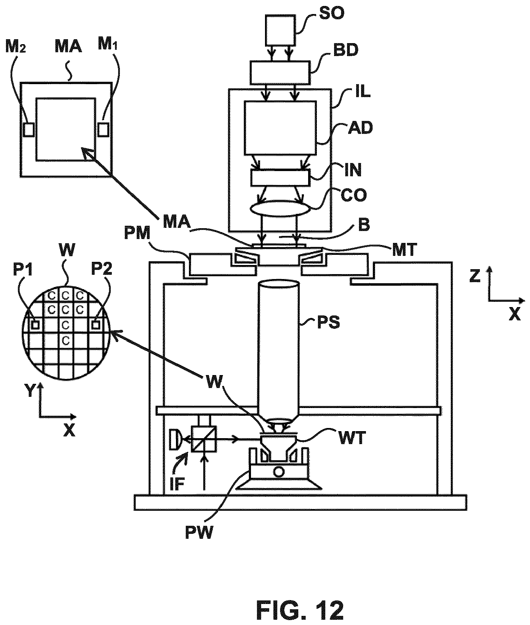

Figure 12 is a schematic diagram of a lithographic projection apparatus, according to an embodiment. The lithographic projection apparatus can include an illumination system IL, a first object table MT, a second object table WT, and a projection system PS. Illumination system IL, can condition a beam B of radiation. In this example, the illumination system also comprises a radiation source SO. First object table (e.g., a patterning device table) MT can be provided with a patterning device holder to hold a patterning device MA (e.g., a reticle), and connected to a first positioner to accurately position the patterning device with respect to item PS. Second object table (e.g., a substrate table) WT can be provided with a substrate holder to hold a substrate W (e.g., a resist-coated silicon wafer), and connected to a second positioner to accurately position the substrate with respect to item PS. Projection system (e.g., which includes a lens) PS (e.g., a refractive, catoptric or catadioptric optical system) can image an irradiated portion of the patterning device MA onto a target portion C (e.g., comprising one or more dies) of the substrate W. Patterning device MA and substrate W may be aligned using patterning device alignment marks M1, M2 and substrate alignment marks PI, P2, for example.

As depicted, the apparatus can be of a transmissive type (i.e., has a transmissive patterning device). However, in general, it may also be of a reflective type, for example (with a reflective patterning device). The apparatus may employ a different kind of patterning device for a classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander, or beam delivery system BD (comprising directing mirrors, the beam expander, etc.). for example. The illuminator IL may comprise adjusting means AD for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

In some embodiments, source SO may be within the housing of the lithographic projection apparatus (as is often the case when source SO is a mercury lamp, for example), but that it may also be remote from the lithographic projection apparatus. The radiation beam that it produces may be led into the apparatus (e.g., with the aid of suitable directing mirrors), for example. This latter scenario can be the case when source SO is an excimer laser (e.g., based on KrF, ArF or F2 lasing), for example.

The beam B can subsequently intercept patterning device MA, which is held on a patterning device table MT. Having traversed patterning device MA, the beam B can pass through the lens PL, which focuses beam B onto target portion C of substrate W. With the aid of the second positioning means (and interferometric measuring means IF), the substrate table WT can be moved accurately, e.g. to position different target portions C in the path of beam B. Similarly, the first positioning means can be used to accurately position patterning device MA with respect to the path of beam B, e.g., after mechanical retrieval of the patterning device MA from a patterning device library, or during a scan. In general, movement of the object tables MT, WT can be realized with the aid of a long-stroke module (coarse positioning) and a short-stroke module (fine positioning). However, in the case of a stepper (as opposed to a step-and-scan tool), patterning device table MT may be connected to a short stroke actuator, or may be fixed.

The depicted tool can be used in two different modes, step mode and scan mode. In step mode, patterning device table MT is kept essentially stationary, and an entire patterning device image is projected in one operation (i.e., a single "flash") onto a target portion C. Substrate table WT can be shifted in the x and/or y directions so that a different target portion C can be irradiated by beam B. In scan mode, essentially the same scenario applies, except that a given target portion C is not exposed in a single "flash." Instead, patterning device table MT is movable in a given direction (e.g., the "scan direction", or the "y" direction) with a speed v, so that projection beam B is caused to scan over a patterning device image. Concurrently, substrate table WT is simultaneously moved in the same or opposite direction at a speed $V = Mv$, in which M is the magnification of the lens (typically, $M = 1/4$ or $1/5$). In this manner, a relatively large target portion C can be exposed, without having to compromise on resolution.

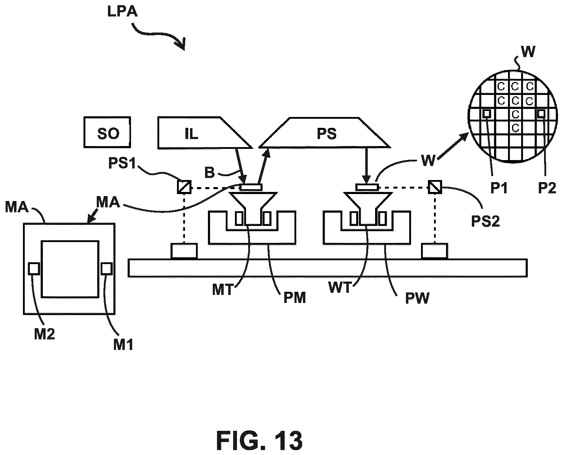

Figure 13 is a schematic diagram of another lithographic projection apparatus (LPA). LPA can include source collector module SO, illumination system (illuminator) IL configured to condition a radiation beam B (e.g. EUV radiation), support structure MT, substrate table WT, and projection system PS. Support structure (e.g. a patterning device table) MT can be constructed to support a patterning device (e.g. a mask or a reticle) MA and connected to a first positioner PM configured to accurately position the patterning device. Substrate table (e.g. a wafer table) WT can be constructed to hold a substrate (e.g. a resist coated wafer) W and connected to a second positioner PW configured to accurately position the substrate. Projection system (e.g. a reflective projection system) PS can be configured to project a pattern imparted to the radiation beam B by patterning device MA onto a target portion C (e.g. comprising one or more dies) of the substrate W.

As shown in this example, LPA can be of a reflective type (e.g. employing a reflective patterning device). It is to be noted that because most materials are absorptive within the EUV wavelength range, the patterning device may have multilayer reflectors comprising, for example, a multi-stack of molybdenum and silicon. In one example, the multi-stack reflector has a 40 layer pairs of molybdenum and silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

Illuminator IL can receive an extreme ultra violet radiation beam from source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP"), the plasma can be produced by irradiating a fuel, such as a droplet, stream or cluster of material having the line-emitting element, with a laser beam. Source collector module SO may be part of an EUV radiation system including a laser (not shown in Figure 10), for providing the laser beam exciting the fuel. The resulting plasma emits output radiation, e.g., EUV radiation, which is collected using a radiation collector, disposed in the source collector module. The laser and the source collector module may be separate entities, for example when a $CO2$ laser is used to provide the laser beam for fuel excitation. In this example, the laser may not be considered to form part of the lithographic apparatus and the radiation beam can be passed from the laser to the source collector module with the aid of a beam delivery system comprising, for example, suitable directing mirrors and/or a beam expander. In other examples, the source may be an integral part of the source collector module, for example when the source is a discharge produced plasma EUV generator, often termed a DPP source.

Illuminator IL may comprise an adjuster for adjusting the angular intensity distribution of the radiation beam. Generally, at least the outer and/or inner radial extent (commonly referred to as $\sigma$-outer and $\sigma$-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B can be incident on the patterning device (e.g., mask) MA, which is held on the support structure (e.g., patterning device table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder, or capacitive sensor), the substrate table WT can be moved accurately (e.g. to position different target portions C in the path of radiation beam B). Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks PI, P2.

The depicted apparatus LPA could be used in at least one of the following modes, step mode, scan mode, and stationary mode. In step mode, the support structure (e.g. patterning device table) MT and the substrate table WT are kept essentially stationary, while an entire pattern imparted to the radiation beam is projected onto a target portion C at one time (e.g., a single static exposure). The substrate table WT is then shifted in the X and/or Y direction so that a different target portion C can be exposed. In scan mode, the support structure (e.g. patterning device table) MT and the substrate table WT are scanned synchronously while a pattern imparted to the radiation beam is projected onto target portion C (i.e. a single dynamic exposure). The velocity and direction of substrate table WT relative to the support structure (e.g. patterning device table) MT may be determined by the (de)magnification and image reversal characteristics of the projection system PS. In stationary mode, the support structure (e.g. patterning device table) MT is kept essentially stationary holding a programmable patterning device, and substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

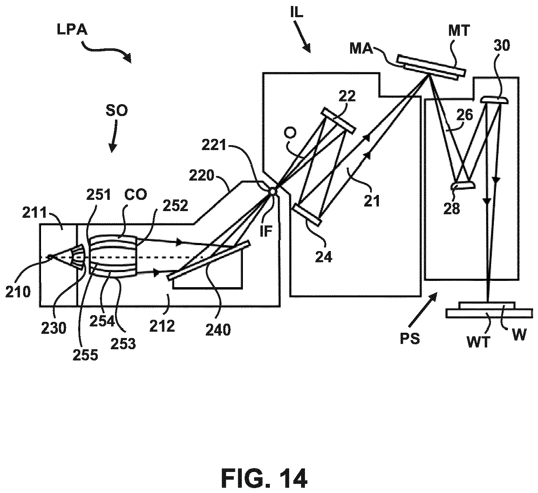

Figure 14 is a detailed view of the lithographic projection apparatus shown in Figure 13. As shown in Figure 14, the LPA can include the source collector module SO, the illumination system IL, and the projection system PS. The source collector module SO is configured such that a vacuum environment can be maintained in an enclosing structure 220 of the source collector module SO. An EUV radiation emitting plasma 210 may be formed by a discharge produced plasma source. EUV radiation may be produced by a gas or vapor, for example Xe gas, Li vapor or Sn vapor in which the hot plasma 210 is created to emit radiation in the EUV range of the electromagnetic spectrum. The hot plasma 210 is created by, for example, an electrical discharge causing at least partially ionized plasma. Partial pressures of, for example, 10 Pa of Xe, Li, Sn vapor or any other suitable gas or vapor may be required for efficient generation of the radiation. In some embodiments, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 (described below) also includes a channel structure. The collector chamber 211 may include a radiation collector CO which may be a grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently, the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT. More elements than shown may generally be present in illumination optics unit IL and projection system PS. The grating spectral filter 240 may optionally be present, depending upon the type of lithographic apparatus, for example. Further, there may be more mirrors present than those shown in the figures, for example there may be 1- 6 additional reflective elements present in the projection system PS than shown in Figure 14.

Collector optic CO, as illustrated in Figure 14, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type may be used in combination with a discharge produced plasma source, often called a DPP source.

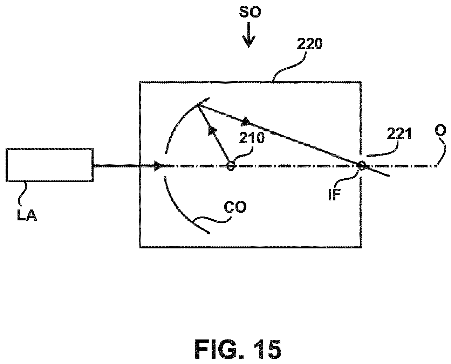

Figure 15 is a detailed view of source collector module SO of the lithographic projection apparatus LPA (shown in previous figures). Source collector module SO may be part of an LPA radiation system. A laser LA can be arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

The embodiments may further be described using the following clauses:

1. A method for enhancing inspection throughput, the method comprising:

generating a plurality of pulsed constituent electron beams; and
combining the plurality of pulsed constituent electron beams into a combined electron inspection beam, the combined electron inspection beam having a greater brightness than each of the individual constituent pulsed electron beams;
wherein the combined electron inspection beam is configured for inspecting a substrate.

2. The method of clause 1, wherein the inspection throughput is a function of the brightness of the combined electron inspection beam, and wherein the greater brightness of the combined electron inspection beam enhances the inspection throughput.

3. The method of clause 1 or 2, wherein the combined electron inspection beam is aligned along a single optical axis.

4. The method of any of clauses 1 to 3, wherein the inspection throughput is associated with a semiconductor manufacturing process, and the substrate is associated with a semiconductor device.

5. The method of any of clauses 1 to 4, wherein pulses of electrons in different ones of the plurality of pulsed constituent electron beams are out of phase with each other such that the combined electron inspection beam is formed by a combination of the out of phase pulses of electrons.

6. The method of any of clauses 1 to 5, wherein generating the plurality of pulsed constituent electron beams comprises:

emitting a plurality of continuous beams of electrons; and
causing energy spread in individual beams of the plurality of continuous beams to create pulses of electrons of similar energies in the individual beams to form the plurality of pulsed constituent electron beams.

7. The method of any of clauses 1 to 6, wherein the plurality of pulsed constituent electron beams is combined into the combined electron inspection beam with a deflecting cavity.

8. The method of any of clauses 1 to 7, wherein generating the plurality of pulsed constituent electron beams comprises emitting the plurality of pulsed constituent electron beams by a corresponding plurality of Schottky emitters or cold field emitters.

9. The method of any of clauses 1 to 8, further comprising accelerating the combined electron inspection beam to reduce effects of coulomb interactions.

10. The method of any of clauses 1 to 9, further comprising:

dispersing electrons in the combined electron inspection beam by energy level such that electrons in the combined electron inspection beam having higher energy follow a relatively shorter path through a chicane, and electrons in the combined electron inspection beam having lower energy follow a relatively longer path through the chicane; and

accelerating the combined electron inspection beam such that the electrons in the combined electron inspection beam having the lower energy gain more energy from the accelerating than the electrons in the combined electron inspection beam having the higher energy so as to reduce an energy spread between the lower energy electrons and the higher energy electrons.

11. The method of clause 10, wherein the inspection throughput is an inverse function of the energy spread, and wherein reducing the energy spread further enhances the inspection throughput.

12. The method of clause 10 or 11, wherein dispersing electrons in the combined electron inspection beam by energy level comprises passing the combined electron inspection beam through a chicane comprising a plurality of magnetic deflectors.

13. The method of clause 12, wherein the chicane comprises four magnetic deflectors.

14. The method of any of clauses 10 to 13, wherein the accelerating is performed by an acceleration cavity.

15. The method of any of clauses 10 to 14, wherein dispersing electrons in the combined electron inspection beam by energy level and accelerating the combined electron inspection beam produces monochromatic electron bunches.

16. The method of any of clauses 1 to 15, wherein the inspection throughput is associated with bright field inspection or multi-beam inspection.

17. The method of any of clauses 1 to 16, wherein the inspection throughput is associated with a scanning electron microscope.

18. The method of any of clauses 1 to 17, wherein the method further comprises:

generating the combined electron inspection beam with a scanning electron microscope; and
correcting a spherical aberration associated with the combined electron inspection beam with a multipole corrector.

19. The method of clause 18, wherein the inspection throughput is a function of correcting the spherical aberration, such that correcting the spherical aberration further enhances the inspection throughput.

20. The method of any of clauses 1 to 19, wherein the plurality of pulsed constituent electron beams comprises at least 10 pulsed constituent electron beams.

21. A method for enhancing inspection throughput, the method comprising:

passing an electron inspection beam through a curved path;
dispersing the electron inspection beam by energy level as the electron inspection beam traverses the cured path such that electrons in the electron inspection beam having higher energy follow a relatively shorter path, and electrons in the electron inspection beam having lower energy follow a relatively longer path; and
accelerating the electron inspection beam such that the electrons in the electron inspection beam having the lower energy gain more energy from the accelerating than the electrons in the electron inspection beam having the higher energy so as to reduce an energy spread between the lower energy electrons and the higher energy electrons;
wherein the accelerated electron inspection beam is configured for inspecting a substrate.

22. The method of clause 21, wherein the curved path comprises a chicane.

23. A method for enhancing inspection throughput, the method comprising:

generating an electron inspection beam with a scanning electron microscope; and
correcting a spherical aberration associated with the electron inspection beam with a multipole corrector;
wherein the corrected electron inspection beam is configured for inspecting a substrate.

24. A computer program product comprising a non-transitory computer readable medium having instructions recorded thereon, the instructions when executed by a computer implementing the method of any of clauses 1 to 23.

25. An inspection system configured to enhance inspection throughput, the system comprising:

a plurality of emitters configured to generate a corresponding plurality of pulsed constituent electron beams; and
an electron optical arrangement configured to combine the plurality of pulsed constituent electron beams into a combined electron inspection beam, the combined electron inspection beam having a greater brightness than each of the individual pulsed constituent electron beams;

wherein the combined electron inspection beam is configured to be used for inspecting a substrate.

26. The system of clause 25, wherein the electron optical arrangement comprises a deflecting cavity.

27. The system of clause 25 or 26, further comprising a curved path configured to disperse the combined electron inspection beam by energy level such that electrons in the combined electron inspection beam having higher energy follow a relatively shorter path, and electrons in the combined electron inspection beam having lower energy follow a relatively longer path; and

an accelerator configured to accelerate the combined electron inspection beam such that the electrons in the combined electron inspection beam having the lower energy gain more energy from the accelerating than the electrons in the combined electron inspection beam having the higher energy so as to reduce an energy spread between the lower energy electrons and the higher energy electrons.

28. The system of clause 27, wherein the curved path is a chicane.

29. The system of clause 28, wherein the chicane comprises a plurality of magnetic deflectors.

30. The system of any of clauses 27 to 29, wherein the accelerator comprises an accelerating cavity.

31. The system of any of clauses 25 to 30, further comprising a multipole corrector configured to correct a spherical aberration associated with the combined electron inspection beam.

32. The system of clause 31, wherein the multipole corrector comprises at least one transfer lens, at least one adaptor lens, at least one alignment deflector, a beam tilt coil, a beam shift coil, and at least one stigmator.

33. The system of any of clauses 25 to 32, wherein pulses of electrons in different ones of the plurality of pulsed constituent electron beams are out of phase with each other such that the combined electron inspection beam is formed by a combination of the out of phase pulses of electrons.

34. The system of any of clauses 25 to 33, wherein the plurality of emitters comprises a plurality of Schottky emitters or cold field emitters.

35. The system of any of clauses 25 to 34, wherein the inspection system is a scanning electron microscope.

36. An inspection system configured to enhance inspection throughput, the system comprising:

a curved path configured to disperse a combined electron inspection beam by energy level such that electrons in the combined electron inspection beam having higher energy follow a relatively shorter path, and electrons in the combined electron inspection beam having lower energy follow a relatively longer path; and

an accelerator configured to accelerate the combined electron inspection beam such that the electrons in the combined electron inspection beam having the lower energy gain more energy from the accelerating than the electrons in the combined electron inspection beam having the higher energy so as to reduce an energy spread between the lower energy electrons and the higher energy electrons;

wherein the combined electron inspection beam is configured to be used for inspecting a substrate.

37. The system of clause 36, wherein the curved path is a chicane.

38. The system of clause 37, wherein the chicane comprises a plurality of magnetic deflectors.

39. A scanning electron microscope inspection system configured to enhance inspection throughput, the system comprising:

a multipole corrector configured to correct a spherical aberration associated with a combined electron inspection beam, wherein the combined electron inspection beam is configured to be used for inspecting a substrate.

40. The system of clause 39, wherein the multipole corrector comprises at least one transfer lens, at least one adaptor lens, at least one alignment deflector, a beam tilt coil, a beam shift coil, and at least one stigmator.

41. A high brightness electron source system, the system comprising:

a plurality of emitters configured to generate a corresponding plurality of pulsed constituent electron beams; and

an electron optical arrangement configured to combine the plurality of pulsed constituent electron beams into a combined electron inspection beam, the combined electron inspection beam having a greater brightness than each of the individual pulsed constituent electron beams.

42. The system of clause 41, wherein the electron optical arrangement comprises a deflecting cavity.

43. The system of clause 41 or 42, further comprising a curved path configured to disperse the combined electron inspection beam by energy level such that electrons in the combined electron inspection beam having higher energy follow a relatively shorter path, and electrons in the combined electron inspection beam having lower energy follow a relatively longer path; and

an accelerator configured to accelerate the combined electron inspection beam such that the electrons in the combined electron inspection beam having the lower energy gain more energy from the accelerating than the electrons in the combined electron inspection beam having the higher energy so as to reduce an energy spread between the lower energy electrons and the higher energy electrons.

44. The system of clause 43, wherein the curved path is a chicane.

45. The system of clause 44, wherein the chicane comprises a plurality of magnetic deflectors.

46. The system of any of clauses 43 to 45, wherein the accelerator comprises an accelerating cavity.

47. The system of any of clauses 41 to 46, further comprising a multipole corrector configured to correct a spherical aberration associated with the combined electron inspection beam.

48. The system of clause 47, wherein the multipole corrector comprises at least one transfer lens, at least one adaptor lens, at least one alignment deflector, a beam tilt coil, a beam shift coil, and at least one stigmator.

49. The system of any of clauses 41 to 49, wherein pulses of electrons in different ones of the plurality of pulsed constituent electron beams are out of phase with each other such that the combined electron inspection beam is formed by a combination of the out of phase pulses of electrons.

50. The system of any of clauses 41 to 49, wherein the plurality of emitters comprises a plurality of Schottky emitters or cold field emitters.

The concepts disclosed herein may simulate or mathematically model any generic imaging system for imaging sub wavelength features, and may be especially useful with emerging imaging technologies capable of producing increasingly shorter wavelengths. Emerging technologies include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-50nm by using a synchrotron or by hitting a material (either solid or a plasma) with high energy electrons in order to produce photons within this range.

While the concepts disclosed herein may be used for wafer manufacturing on a substrate such as a silicon wafer, it shall be understood that the disclosed concepts may be used with any type of manufacturing system (e.g., those used for manufacturing on substrates other than silicon wafers). In addition, the combination and sub-combinations of disclosed elements may comprise separate embodiments. For example, separate embodiments of the method described herein may include one or more of the beam generation components, the beam combining components, the chicane, the acceleration components, the corrector components, and/or other components. As another example, any or all of these components may be combined in a single embodiment.

The descriptions above are intended to be illustrative, not limiting. Thus, it will be apparent to one skilled in the art that modifications may be made as described without departing from the scope of the claims set out below.

## Claims

1. A high brightness electron source system, the system comprising:

    a plurality of emitters configured to generate a corresponding plurality of pulsed constituent electron beams; and
    an electron optical arrangement configured to combine the plurality of pulsed constituent electron beams into a combined electron inspection beam, the combined electron inspection beam having a greater brightness than each of the individual pulsed constituent electron beams.

2. The system of claim 1, wherein the electron optical arrangement comprises a deflecting cavity.

3. The system of claim 1, further comprising a curved path configured to disperse the combined electron inspection beam by energy level such that electrons in the combined electron inspection beam having higher energy follow a relatively shorter path, and electrons in the combined electron inspection beam having lower energy follow a relatively longer path; and
an accelerator configured to accelerate the combined electron inspection beam such that the electrons in the combined electron inspection beam having the lower energy gain more energy from the accelerating than the electrons in the combined electron inspection beam having the higher energy so as to reduce an energy spread between the lower energy electrons and the higher energy electrons.

4. The system of claim 3, wherein the curved path is a chicane.

5. The system of claim 4, wherein the chicane comprises a plurality of magnetic deflectors.

6. The system of claim 3, wherein the accelerator comprises an accelerating cavity.

**7.** The system of claim 1, further comprising a multipole corrector configured to correct a spherical aberration associated with the combined electron inspection beam.

**8.** The system of claim 7, wherein the multipole corrector comprises at least one transfer lens, at least one adaptor lens, at least one alignment deflector, a beam tilt coil, a beam shift coil, and at least one stigmator.

**9.** The system of claim 1, wherein pulses of electrons in different ones of the plurality of pulsed constituent electron beams are out of phase with each other such that the combined electron inspection beam is formed by a combination of the out of phase pulses of electrons.

**10.** The system of claim 1, wherein the plurality of emitters comprises a plurality of Schottky emitters or cold field emitters.

**11.** An inspection system configured to enhance inspection throughput, wherein the system comprises the high brightness electron source system according to claim 1.

**12.** A method for enhancing inspection throughput, the method comprising:

generating a plurality of pulsed constituent electron beams; and
combining the plurality of pulsed constituent electron beams into a combined electron inspection beam, the combined electron inspection beam having a greater brightness than each of the individual constituent pulsed electron beams;
wherein the combined electron inspection beam is configured for inspecting a substrate.

**13.** The method of claim 12, wherein the inspection throughput is a function of the brightness of the combined electron inspection beam, and wherein the greater brightness of the combined electron inspection beam enhances the inspection throughput.

**14.** The method of claim 12, wherein the combined electron inspection beam is aligned along a single optical axis.

**15.** The method of claim 12, wherein generating the plurality of pulsed constituent electron beams comprises:

emitting a plurality of continuous beams of electrons; and
causing energy spread in individual beams of the plurality of continuous beams to create pulses of electrons of similar energies in the individual beams to form the plurality of pulsed constituent electron beams.

10A

12A

14A

16Aa, 16Ab

18A

20A

16Ac

22A

**FIG. 1**

**FIG. 2**

**FIG. 3**

**FIG. 4**

500

502

504

512

510

506 → 

e⁻

508 → 

FIG. 5

**FIG. 6**

FIG. 7

**FIG. 8**

**FIG. 9**

**FIG. 10**

**FIG. 11**

**FIG. 12**

**FIG. 13**

**FIG. 14**

**FIG. 15**

Europäisches
Patentamt

European
Patent Office

Office européen
des brevets

**EUROPEAN SEARCH REPORT**

Application Number

EP 20 15 0403

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 10 276 346 B1 (DUFFY BRIAN [US] ET AL) 30 April 2019 (2019-04-30) * figure 1B * * column 9, lines 4-10 * * column 9, lines 15-19 * * column 8, lines 4-14 * ----- | 1,2, 11-14 | INV. H01J37/28 H01J37/06 H01J37/073 |

TECHNICAL FIELDS
SEARCHED      (IPC)

H01J

~~The present search report has been drawn up for all claims~~

| Place of search | Date of completion of the search | Examiner |
|---|---|---|
| Munich | 14 July 2020 | Chevrier, Dominique |

EPO FORM 1503 03.82 (P04C01)

Europäisches
Patentamt

European
Patent Office

Office européen
des brevets

Application Number

EP 20 15 0403

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1, 2, 11-14

☐ The present supplementary European search report has been drawn up for those parts of the European patent application which relate to the invention first mentioned in the claims (Rule 164 (1) EPC).

**Europäisches Patentamt**
**European Patent Office**
**Office européen des brevets**

# LACK OF UNITY OF INVENTION
## SHEET B

The Search Division considers that the present European patent application does not comply with the requirements of unity of invention and relates to several inventions or groups of inventions, namely:

1. claims: 1, 2, 11-14

   A high brightness electron source system/method comprising : a deflecting cavity for aligning a plurality of electron beams along a single optical axis.
   ---

2. claims: 3-6, 15

   A high brightness electron source system/method comprising : means causing energy spread in beam(s)
   ---

3. claims: 7, 8

   A high brightness electron source system comprising : a multipole corrector configured to correct a spherical aberration
   ---

4. claim: 9

   A high brightness electron source system comprising : means for generating out of phase pulsed electron beams
   ---

5. claim: 10

   A high brightness electron source system comprising : a plurality of Schottky emitters or cold field emitters
   ---

## ANNEX TO THE EUROPEAN SEARCH REPORT
## ON EUROPEAN PATENT APPLICATION NO.

EP 20 15 0403

This annex lists the patent family members relating to the patent documents cited in the above-mentioned European search report.
The members are as contained in the European Patent Office EDP file on
The European Patent Office is in no way liable for these particulars which are merely given for the purpose of information.

14-07-2020

| Patent document cited in search report | | Publication date | Patent family member(s) | Publication date |
|---|---|---|---|---|
| US 10276346 | B1 | 30-04-2019 | NONE | |

EPO FORM P0459

For more details about this annex : see Official Journal of the European Patent Office, No. 12/82

**EP 3 848 953 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6046792 A
- US 5229872 A
- US 20090157630 A
- US 20080301620 A
- US 20070050749 A
- US 20070031745 A
- US 20080309897 A
- US 20100162197 A
- US 20100180251 A